(19) Europäisches Patentamt
European Patent Office
Office européen des brevets

(11) **EP 2 601 735 B1**

(12) **EUROPÄISCHE PATENTSCHRIFT**

(45) Veröffentlichungstag und Bekanntmachung des Hinweises auf die Patenterteilung:
**04.04.2018 Patentblatt 2018/14**

(21) Anmeldenummer: **11723092.0**

(22) Anmeldetag: **07.06.2011**

(51) Int Cl.:
**H02M 7/06** *(2006.01)*    **H01L 29/872** *(2006.01)*

(86) Internationale Anmeldenummer:
**PCT/EP2011/059342**

(87) Internationale Veröffentlichungsnummer:
**WO 2012/016733 (09.02.2012 Gazette 2012/06)**

(54) **VERFAHREN ZUM BETREIBEN EINES GENERATORS MIT EINER GLEICHRICHTERANORDNUNG, WELCHE SCHOTTKYDIODEN AUFWEIST**

METHOD OF OPERATING A GENERATOR COMPRISING A RECTIFIER CIRCUIT HAVING SCHOTTKY DIODES

PROCÉDÉ DE FONCTIONNEMENT D'UN GENERATEUR COMPRENANT UN CIRCUIT REDRESSEUR PRÉSENTANT DES DIODES SCHOTTKY

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.08.2010 DE 102010038879**

(43) Veröffentlichungstag der Anmeldung:
**12.06.2013 Patentblatt 2013/24**

(73) Patentinhaber:
• **Robert Bosch GmbH**
**70442 Stuttgart (DE)**
• **SEG Automotive Germany GmbH**
**70499 Stuttgart (DE)**

(72) Erfinder: **GOERLACH, Alfred**
**72127 Kusterdingen (DE)**

(56) Entgegenhaltungen:
**DE-A1- 19 549 202      DE-A1-102004 053 761**
**DE-A1-102004 056 663**

• **Anonymous: "AN869 APPLICATION NOTE - Tj MAX LIMIT OF SCHOTTKY DIODES", , 10 May 2004 (2004-05-10), XP055362683, Retrieved from the Internet: URL:http://www.st.com/resource/en/applicat ion_note/cd00003976.pdf [retrieved on 2017-04-06]**

EP 2 601 735 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Betreiben eines Generators, mit einer Gleichrichteranordnung, welche Schottkydioden, insbesondere Einpressdioden, aufweist.

Stand der Technik

In Kfz-Generatorsystemen werden zur Gleichrichtung des Wechsel- bzw. Drehstroms meist Dioden aus Silizium eingesetzt. Beispielsweise werden 6 Dioden zu einer B6-Gleichrichterbrücke zusammengeschaltet. Diese Dioden sind meist als sogenannte Einpressdioden ausgeführt. Einpressdioden werden auf einer Seite in die Kühlkörper des Gleichrichters eingepresst und sind damit elektrisch und thermisch fest und dauerhaft mit dem Kühlkörper des Gleichrichters verbunden.

Während des Gleichrichterbetriebs fällt an den Dioden eine elektrische Verlustleistung Pel ab, die sich aus den Vorwärts- bzw. Flussverlusten PF und den Sperrverlusten PR zusammensetzt und in Wärme umgewandelt wird. Diese wird über den Gleichrichter an die Kühl- oder Ansaugluft des Generators abgeführt. Da die Kühlleistung von Kfz-Generatoren bei niedrigen Generatordrehzahlen noch relativ gering ist, andererseits die elektrische Leistungsabgabe mit zunehmender Generatordrehzahl aber schnell ansteigt, existiert eine Drehzahl - meist im Bereich von 2500 - 3500 Umdrehungen / Minute - bei der die Diodentemperaturen am höchsten sind. Dieser Betriebspunkt wird als Heißpunkt bezeichnet. Die maximal zulässige Sperrschichttemperatur der Dioden muss mindestens für den Betrieb im Heißpunkt ausgelegt sein.

Für eine symmetrische Gleichrichteranordnung, wie beispielsweise bei einer B6-Brücke, ergibt sich die mittlere elektrische Vorwärtsverlustleistung PF aus dem Produkt des arithmetischen Mittels des Fluss- oder Vorwärtsstroms IFAV und der temperaturabhängigen Flussspannung UF(T) einer Diode zu:

$$PF = IFAV \cdot UF(T) \qquad (1)$$

Bei Kfz-Dioden nimmt die Flussspannung UF(T) i. a. mit der Temperatur ab. Im relevanten Strombereich beträgt der Temperaturkoeffizient TKUF z. B. etwa -1 mV/K.

Vorwärtsverluste PF können reduziert werden, wenn statt üblicher pn-Dioden Schottkydioden mit niedrigerer Flussspannung UF eingesetzt werden. Durch die geringeren Durchlassverluste der Schottkydioden erhöhen sich Wirkungsgrad und Abgabeleistung des Generators. In besonders vorteilhafter Weise werden sogenannte Hocheffizienzdioden (HEDs), welche einen sperrspannungsunabhängigen Sperrstrom aufweisen, eingesetzt. HEDs sind beispielsweise Trench-MOS-Barrier-Schottky Dioden (TMBS) oder Trench-Junction-Barrier-Schottky Dioden (TJBS). Derartige Dioden werden beispielsweise in der DE 694 28 996 T2, der DE 10 2004 053 761 A1 und der DE 10 2004 056 663 beschrieben.

Aus Application Note AN869 "Tj MAX LIMIT OF SCHOTTKY DIODES" ist bekannt, dass Schottkydioden unter Umständen bei höheren Temperaturen betrieben werden dürfen, als die in den jeweiligen Datenblätter angegebenen maximal zulässigen Sperrschichttemperaturen. Während bei üblichen pn-Dioden die Sperrverluste meist vernachlässigbar sind, treten bei Schottkydioden oder HEDs infolge der niedrigen Flussspannung bei hohen Temperaturen allerdings nennenswerte Sperrverluste auf. Für die mittleren Sperrverluste PR gilt bei einer Sperrspannung UR, die etwa der Generatorspannung entspricht:

$$PR = 0{,}5 \cdot IR(T) \cdot UR \qquad (2)$$

Der Sperrstrom IR(T) bei einer gegebenen Sperrspannung UR hängt ebenfalls von der Temperatur ab. Er steigt mit der Temperatur schnell an. Der Sperrstrom kann im relevanten Temperaturbereich mittels zweier Konstanten Ioo und Ea ausgedrückt werden. Dabei beschreibt Ioo den Strom bei unendlich hoher Temperatur in Ampere und Ea die Aktivierungsenergie in Kelvin. Es gilt:

$$IR(T) \approx Ioo \cdot e^{-\left(\frac{Ea}{T}\right)} \qquad (3)$$

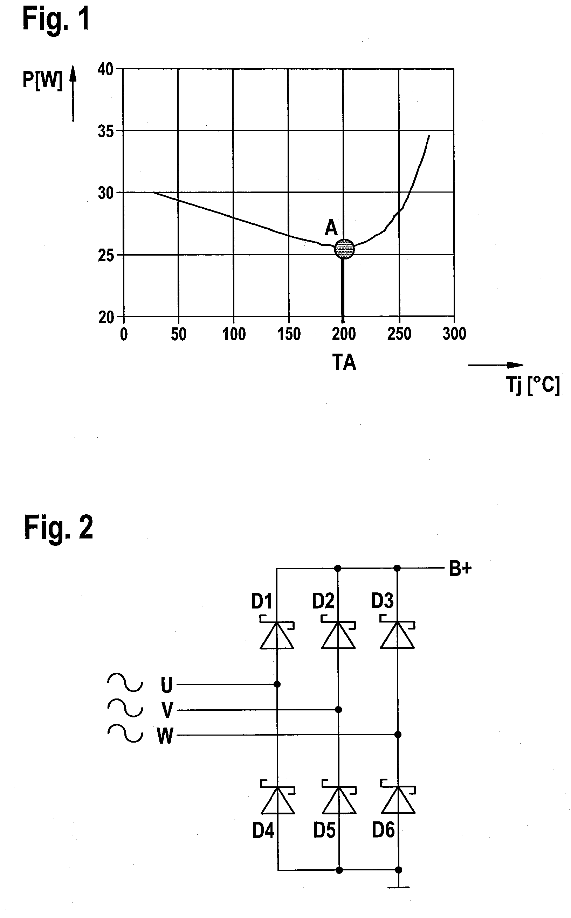

Mit den angegebenen Abhängigkeiten ist in **Fig. 1** ein Diagramm für die mittlere Gesamtverlustleistung P(W) einer HED bei einen Flussstrom IFAV=50A und einer Sperrspannung UR=14V über der Sperrschichttemperatur Tj dargestellt. Dabei wurde eine Diode mit den Parametern Ioo=4·10⁷ A und Ea=9300K ausgewählt.

Bei niedrigen Temperaturen können die Sperrverluste gegenüber den Vorwärtsverlusten vernachlässigt werden. Da die Flussspannung wegen des negativen Temperaturkoeffizienten mit zunehmender Temperatur absinkt, ist das System thermisch stabil. Bei höheren Temperaturen steigen die Sperrverluste PR an und übersteigen schließlich sogar die Vorwärtsverluste PF. Danach nimmt die Gesamtverlustleistung P(W) mit zunehmender Temperatur zu. In **Fig.1** ist die Stelle, ab der die Gesamtverlustleistung mit der Temperatur zunimmt, als Wendepunkt A eingezeichnet. Die Sperrschichttemperatur des Wendepunktes A ist mit TA bezeichnet. Im gezeigten Beispiel beträgt TA = 200°C.

Übersteigt die Sperrschichttemperatur Tj diesen Wendepunkt bei TA, besteht die Gefahr einer thermischen Instabilität, da infolge des Sperrstromanstieges mit zunehmender Temperatur die Sperrströme immer weiter ansteigen können. Dies entspricht einem thermischen Weglaufen durch das Auftreten eines Rückkoppelungseffektes des Sperrstromes.

Aus den vorstehenden Gründen werden Gleichrichteranordnungen, welche als Einpressdioden realisierte Schottkydioden enthalten, stets in einem Arbeitsbereich betrieben, der unterhalb des Wendepunktes A liegt, d. h. in einem Arbeitsbereich, in welchem die Diodenverluste mit zunehmender Temperatur abnehmen.

Offenbarung der Erfindung

Bei einem Verfahren mit den im Anspruch 1 angegebenen Merkmalen ist der Arbeitsbereich der Gleichrichteranordnung vergrößert. Dies wird im Wesentlichen dadurch erreicht, dass die Gleichrichteranordnung nicht nur in einem Arbeitsbereich betrieben wird, in welchem die Diodenverluste mit zunehmender Temperatur abnehmen, sondern auch in einem Bereich, in welchem die Diodenverluste mit zunehmender Temperatur wieder zunehmen. Dabei wird durch eine Auslegungsvorschrift, die noch unten erläutert wird, erreicht, dass die Gleichrichteranordnung auch in dem Bereich, in welchem die Diodenverluste mit zunehmender Temperatur wieder zunehmen, sicher betrieben werden kann.

Nachfolgend wird die Erfindung anhand der Figuren 2 bis 5 näher erläutert. Es zeigt

Figur 2    eine Gleichrichteranordnung, die insgesamt sechs in Form einer B6-Brücke verschaltete Schottkydioden aufweist,

Figur 3    eine Skizze zur Erläuterung des Aufbaus einer Einpressdiode,

Figur 4    eine Skizze zur Erläuterung einer Trench-MOS-Barrier-Schottkydiode und

Figur 5    ein Diagramm zur Erläuterung des Arbeitsbereiches einer Gleichrichteranordnung, die Teil eines gemäß des erfinderischen Verfahrens betriebenen Generators ist.

Die Figur 2 zeigt eine Gleichrichteranordnung, die insgesamt sechs in Form einer B6-Brücke miteinander verschaltete Schottkydioden D1 bis D6 aufweist. Diese Gleichrichter-Brückenschaltung ist für einen 3-phasigen Kraftfahrzeug-Generator vorgesehen. Mit U, V, W sind die Phasenanschlüsse der Brückenschaltung, mit B+ die positive Gleichstromquelle der Brückenschaltung bezeichnet. Natürlich sind auch Gleichrichteranordnungen mit einer anderen Phasenzahl, beispielsweise mit 5, 6 oder 7 Phasen, möglich.

Die Gleichrichterdioden der in der Figur 2 gezeigten Gleichrichteranordnung sind in Einpressgehäusen montiert. Die Gleichrichterdioden können insbesondere Einpressdioden, die als Halbleiterelement wenigstens eine Schottkydiode enthalten, sein.

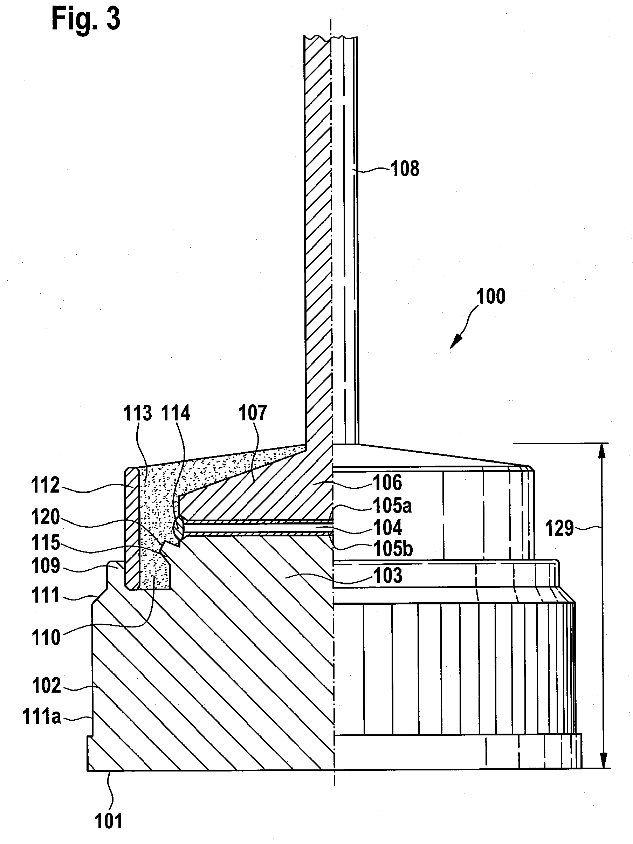

Die Figur 3 zeigt eine Skizze zur Erläuterung des Aufbaus einer gängigen Einpressdiode 100, die in einem teilweise aufgeschnitten Querschnitt dargestellt ist. Diese Diode 100 besitzt einen Sockel 102 mit einem Sockelboden 101. Mit dem Sockel 102 ist einstückig ein Podest 103 verbunden, auf dem seinerseits, beispielsweise durch Löten (Lot 105b), ein Halbleiterchip angebracht ist. Der Halbleiterchip 104 seinerseits ist beispielsweise wiederum durch Löten (Lot 105a) über einen Kopfzylinder 106 und einen Kopfkegel 107 mit einem Kopfdraht 108 verbunden. Das vorzugsweise zentriert angeordnete Podest 103 ist von einem umlaufenden Wall 109 und einen durch den Wall 109 und das Podest 103 gebildeten Graben 110 umgeben. Vom Podest 103 aus betrachtet befindet sich jenseits des Walls 109 noch ein Pressbereich 111, der sich an den Rändelbereich 111a anschließt, auf den beim Einpressen der Gleichrichterdiode 100 Kräfte senkrecht zur Ebene des Halbleiterchips 104 einwirken können. Der Kopfkegel 107, der Kopfizylinder 106, der Halbleiterchip 104 und das Podest 103 sind von einer Verpackung 113 umgeben, die von einer Schutzhülse 112 begrenzt wird. Das Podest 103 und der Kopfzylinder 106 weisen zum Halbleiterchip hin am Rande eine Fase auf. Die Fasen können beispielsweise mit Lot ausgefüllt sein. Ferner ist am Rande des Chips eine Passivierung 114 angebracht, die den Chip und das Lot am Chiprand versiegelt. Ferner weist das Podest 103 eine umlaufende Schulter 115 mit einer schrägen Kante 120 auf, die in die Verpackung 113 hineinragt.

Bei der in der Figur 3 gezeigten Gleichrichterdiode 100 ist der Halbleiterchip 104 auf einem erhöhten Podest 103 befestigt, der von einem Wall 109 umgeben ist. Der so gebildete Graben 110 hat dabei eine Länge, die doppelt so groß ist wie die Höhe des Walls 109. Der Vorteil besteht darin, dass die Konstruktion besonders robust ist gegenüber Deformationen beim Einpressen der Gleichrichterdiode. Die Kombination von Podest und Wall/Graben gewährleistet eine homogenere und niedrigere Biegebeanspruchung an der Chipauflagefläche im Vergleich zu einer Konstruktion ohne signifikant ausgebildeten Wall 109. Ein weiterer Vorteil ist, dass die Chipzentrierung unkritisch ist. Vorzugsweise ist der Wall niedriger als das Podest, unter anderem um den Zugang zum Chip bei der Herstellung der Diode und bei der Passivierung nicht zu beeinträchtigen.

Gemäß der Figur 3 weist die Gleichrichterdiode 100 an ihrem Sockel 102, beispielsweise am Umfang des Podests 103, eine Schulter 115 auf. Diese Schulter dient dazu, einen Formschluss der Verpackung mit dem Sockel herzustellen. Zum einen ergibt sich mechanische Stabilität, der Sockel ist gewissermaßen mit der Verpackung 113 verhakt. Zum anderen drückt eine beispielsweise als Giesharzmasse ausgeführt Verpackung bei der Herstellung beim Austrocknen den Kopfteil der Diode samt Halbleiterchip auf den Sockel auf. So ergibt sich insgesamt eine stabile Konstruktion. Die Schulter 115 weist dabei eine schräge Kante 120 auf, wodurch das Auftreten hoher mechanischer Spannungen und die Gefahr einer Rissbildung in der Verpackung bei äußeren mechanischen, aber auch bei thermischen Belastungen, vermieden wird, die bei einem spitz zulaufenden Ende der Schulter bestehen würde.

Selbstverständlich können auch andere Varianten von Einpressdioden Verwendung finden.

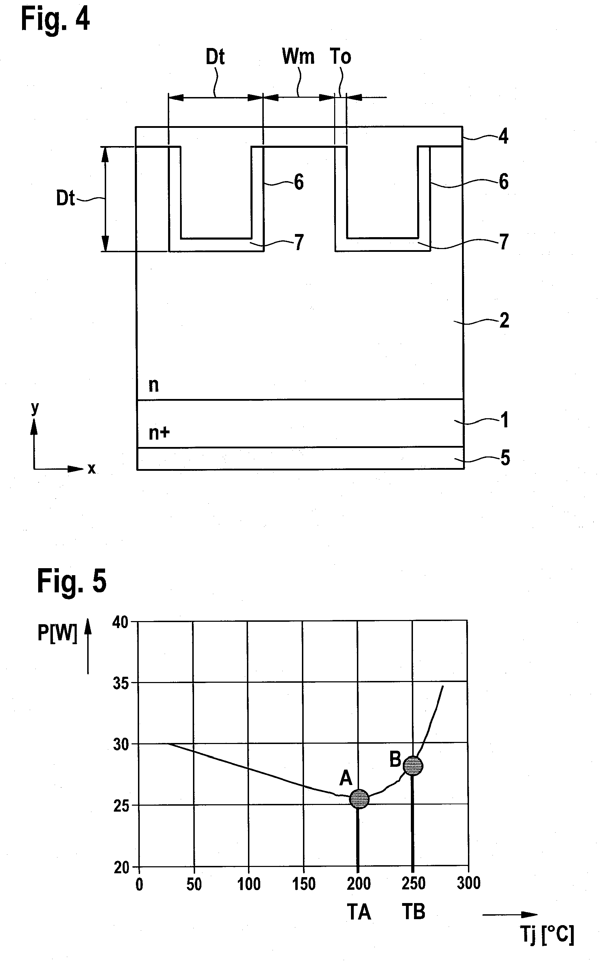

Die Figur 4 zeigt eine Skizze zur Erläuterung einer Trench-MOS-Barrier-Schottkydiode (TMBS-Diode), die bei einer Gleichrichteranordnung verwendet wird, die Teil eines gemäß des erfinderischen Verfahrens betriebenen Generators ist. Eine derartige TMBS-Diode besteht aus einem n+-Substrat 1, einer n-Epischicht 2, mindestens zwei in der n-Epischicht durch Ätzen realisierte Gräben (Trenchs) 6, Metallschichten an der Vorderseite 4 des Chips als Annodenelektrode und an der Rückseite 5 des Chips als Kathodenelektrode und einer Oxidschicht 7 zwischen den Gräben 6 und der Metallschicht an der Vorderseite 4.

Elektrisch gesehen ist eine TMBS-Diode eine Kombination einer MOS-Struktur (Metallschicht, Oxidschicht 7 und n-Epischicht 2) und einer Schottky-Diode (Schottky-Barriere zwischen der Metallschicht als Annode und der n-Epischicht 2 als Kathode).

In der Flussrichtung fließen Ströme durch den Mesa-Bereich zwischen den Gräben 6. Die Gräben 6 selber stehen für den Stromfluss nicht zur Verfügung.

Der Vorteil einer TMBS-Diode liegt in der Reduktion der Sperrströme. In der Sperrrichtung bilden sich sowohl bei der MOS-Struktur als auch bei der Schottky-Diode Raumladungszonen aus. Die Raumladungszonen dehnen sich mit steigender Spannung aus und stoßen bei einer Spannung, die kleiner als die Durchbruchsspannung der TMBS ist, in der Mitte des Bereichs zwischen den benachbarten Gräben 6 zusammen. Dadurch werden die für die hohen Sperrströme verantwortlichen Schottky-Effekte abgeschirmt und die Sperrströme reduziert. Dieser Abschirmeffekt ist stark von den Strukturparametern Dt (Tiefe des Grabens), Wm (Abstand zwischen den Gräben), Wt (Breite des Grabens) sowie von To (Dicke der Oxidschicht) abhängig.

Bei einem Gleichrichter mit Dioden, insbesondere Einpressdioden kann der Wärmewiderstand des Gleichrichters, der sich beispielsweise bei Betrieb im Heißpunkt eines Generators einstellt, über den gesamten Betriebszeitraum stabil unterhalb eines bestimmten Wertes gehalten werden, da sich die thermischen Eigenschaften des robusten Einpresskontaktes praktisch nicht verändern.

Die durch die elektrischen Sperrströme IR(T) erzeugte Verlustleistung wird als Wärme über den Gleichrichter abgeführt, d. h. die elektrische Verlustleistung jeder Diode Pel muss als Wärmeleistung Ptherm über den Gleichrichter zur Umgebungsluft abgeführt werden. Ptherm entspricht dabei dem Quotienten aus der Temperaturdifferenz dT zwischen der Sperrschichttemperatur Tj und der Umgebungs- oder Kühllufttemperatur Ta und dem thermischen Widerstand Rth zwischen Sperrschicht und Umgebungsluft. Der thermische Widerstand ändert sich mit der Generatordrehzahl und bezeichnet deshalb hier den thermischen Widerstand, der bei Betrieb im Heißpunkt auftritt. Eine Diode ist thermisch stabil, solange gilt:

$$\frac{dPel}{dT} \leq \frac{dPtherm}{dT} \qquad\qquad (4)$$

Da die Vorwärtsverluste PF einer Diode einen negativen Temperaturkoeffizienten aufweisen, können sie in Gleichung (4) vernachlässigt werden. Mit der Sperrstromabhängigkeit aus Gleichung (3) ist ein sicheres Betreiben bei hohen Temperaturen ohne thermisches Weglaufen gemäß Gleichung (4) möglich, wenn gilt:

$$\frac{1}{2} \cdot UR \cdot Rth \cdot \frac{Ea}{T^2} \cdot IR(T) \leq 1 \qquad\qquad (5)$$

Die Figur 5 zeigt ein Diagramm zur Erläuterung des Arbeitsbereiches einer Gleichrichteranordnung, die Teil eines gemäß des erfinderischen Verfahrens betriebenen Generators ist. Dabei ist wie in der Figur 1 längs der Abszisse die Temperatur Tj (°C) und längs der Ordinate die Gesamtverlustleistung P(W) aufgetragen. Bei diesem Ausführungsbeispiel wurde für eine Diode des Gleichrichters ein thermischer Widerstand Rth zwischen der Sperrschicht der Diode und Kühlluft von 5 Kelvin/Watt für eine Sperrspannung UR = 14 V und einen Flussstrom IFAV = 50 A dargestellt. Die Diode kann weit oberhalb der konventionellen Sperrschicht-Temperaturgrenze betrieben werden. Im gezeigten Beispiel ist die maximale Sperrschichttemperatur TA von 200 °C bis auf eine Temperatur TB von nahezu 250 °C ausgeweitet. Dies bedeutet, dass sich der Arbeitsbereich, in welchem die Schottkydioden betrieben werden können, auch auf den Temperaturbereich erstreckt, bei dem die Diodenverluste mit zunehmender Temperatur wieder ansteigen.

Der Wärmewiderstand zwischen der Sperrschicht des Halbleiters und der Umgebungsluft bei Betrieb im Heißpunkt des Generators überschreitet einen vorgegebenen Wert nicht. Beispielsweise ist der genannte Wärmewiderstand kleiner als 7 K/W, vorzugsweise kleiner als 5 K/W und in besonders bevorzugter Weise kleiner als 3 K/W.

Die maximal zulässige Sperrschichttemperatur einer Diode wird - wie bereits oben ausgeführt wurde - gemäß der folgenden Beziehung ermittelt:

$$\frac{1}{2} \cdot UR \cdot Rth \cdot \frac{Ea}{T^2} \cdot IR(T) \leq 1.$$

Als Schottkydiode kommen - wie bereits oben ausgeführt wurde - vorzugsweise Trench-MOS-Barrier-Schottkydioden zum Einsatz, deren Grabentiefe 1 μm bis 3 μm betragen und deren Abstand von Graben zu Graben 0,5 μm bis 1 μm beträgt.

Alternativ dazu kommen als Schottkydioden Trench-Junction-Barrier-Schottkydioden (TJBS-Dioden) zum Einsatz, deren Grabentiefe 1 μm bis 3 μm und deren Abstand von Graben zu Graben 0,5 μm bis 1 μm beträgt.

Vorzugsweise handelt es sich bei den Schottkydioden um Dioden mit einer Schottky-Barriere von 0,65 eV bis 0,75 eV.

**Patentansprüche**

1. Verfahren zum Betreiben eines Generator mit einer Gleichrichteranordnung mit Dioden, die als Halbleiterelement eine Schottkydiode enthalten, wobei der Generator einen Heißpunkt aufweist, bei dem in Abhängigkeit von der Generatordrehzahl eine Sperrschichttemperatur der Dioden am höchsten ist, wobei der Wärmewiderstand (Rth) zwischen einer Sperrschicht des Halbleiters des Halbleiterelements und Umgebungsluft bei Betrieb im Heißpunkt des Generators einen vorgegebenen Wert nicht überschreitet, wobei die maximal zulässige Sperrschichttemperatur der Dioden mindestens für den Betrieb im Heißpunkt ausgelegt ist, **dadurch gekennzeichnet, dass** der Generator und somit die Schottkydioden (DI -D6) in einem Arbeitsbereich betrieben werden, in dem die Diodenverluste mit zunehmender Sperrschichttemperatur ansteigen, und dass im Heißpunkt die maximal zulässige Sperrschichttemperatur T der Dioden folgende Beziehung erfüllt:

$$\frac{1}{2} \cdot UR \cdot Rth \cdot \frac{Ea}{T^2} \cdot IR(T) \leq 1$$

wobei Rth der Wärmewiderstand im Heißpunkt, UR die Sperrspannung, IR(T) der Sperrstrom, T die Temperatur der Sperrschicht und Ea die Aktivierungsenergie ist.

2. Verfahren nach Anspruch 1, **dadurch gekennzeichnet, dass** der Wärmewiderstand zwischen Sperrschicht des Halbleiters und Umgebungsluft bei Betrieb im Heißpunkt des Generators kleiner als 7 K/W ist.

3. Verfahren nach Anspruch 1, **dadurch gekennzeichnet, dass** der Wärmewiderstand zwischen Sperrschicht des Halbleiters und Umgebungsluft bei Betrieb im Heißpunkt des Generators kleiner als 5 K/W ist.

4. Verfahren nach Anspruch 1, **dadurch gekennzeichnet, dass** der Wärmewiderstand zwischen Sperrschicht des Halbleiters und Umgebungsluft bei Betrieb im Heißpunkt des Generators kleiner als 3 K/W ist.

5. Verfahren nach einem der vorhergehenden Ansprüche, **dadurch gekennzeichnet, dass** als Schottkydiode eine Trench-MOS-Barrier-Schottkydiode (TMBS) verwendet wird.

**6.** Verfahren nach Anspruch 5, **dadurch gekennzeichnet**, das als Schottkydiode eine Trench-MOS-Barrier-Schottkydiode (TMBS) verwendet wird, bei der die Grabentiefe 1 - 3 $\mu$m und der Abstand von Graben zu Graben 0,5 - 1 $\mu$m beträgt.

**7.** Verfahren nach einem der Ansprüche 1 bis 4, **dadurch gekennzeichnet, dass** als Schottkydiode eine Trench-Junction-Barrier-Schottkydiode (TJBS) verwendet wird.

**8.** Verfahren nach Anspruch 7, **dadurch gekennzeichnet**, das als Schottkydiode eine Trench-Junction-Barrier-Schottkydiode (TJBS) verwendet wird, bei der die Grabentiefe 1 - 3 $\mu$m und der Abstand von Graben zu Graben 0,5 - 1 $\mu$m beträgt.

**9.** Verfahren nach einem der vorhergehenden Ansprüche, **dadurch gekennzeichnet, dass** als Schottkydioden Dioden mit einer Schottky-Barriere von 0,65eV bis 0,75eV verwendet werden.

**Claims**

**1.** Method for operating a generator having a rectifier arrangement having diodes that contain a Schottky diode as a semiconductor element, wherein the generator has a hot point, at which a junction temperature of the diodes is the highest depending on the rotational speed of the generator, wherein the thermal resistance (Rth) between a depletion layer of the semiconductor of the semiconductor element and ambient air during operation at the hot point of the generator does not exceed a predefined value, wherein the maximum permissible junction temperature of the diodes is designed at least for operation at the hot point, **characterized in that** the generator and thus the Schottky diodes (D1-D6) are operated in an operating range in which the diode losses increase as the junction temperature increases, and **in that** at the hot point the maximum permissible junction temperature T of the diodes satisfies the following relationship:

$$\frac{1}{2} \cdot UR \cdot Rth \cdot \frac{Ea}{T^2} \cdot IR(T) \leq 1$$

wherein Rth is the thermal resistance at the hot point, UR is the reverse voltage, IR(T) is the reverse current, T is the temperature of the depletion layer, and Ea is the activation energy.

**2.** Method according to Claim 1, **characterized in that** the thermal resistance between the depletion layer of the semiconductor and ambient air during operation at the hot point of the generator is less than 7 K/W.

**3.** Method according to Claim 1, **characterized in that** the thermal resistance between the depletion layer of the semiconductor and ambient air during operation at the hot point of the generator is less than 5 K/W.

**4.** Method according to Claim 1, **characterized in that** the thermal resistance between the depletion layer of the semiconductor and ambient air during operation at the hot point of the generator is less than 3 K/W.

**5.** Method according to any of the preceding claims, **characterized in that** a trench MOS barrier Schottky diode (TMBS) is used as the Schottky diode.

**6.** Method according to Claim 5, **characterized in that** a trench MOS barrier Schottky diode (TMBS) in which the trench depth is 1-3 $\mu$m and the trench-to-trench distance is 0.5 - 1 $\mu$m is used as the Schottky diode.

**7.** Method according to any of Claims 1 to 4, **characterized in that** a trench junction barrier Schottky diode (TJBS) is used as the Schottky diode.

**8.** Method according to Claim 7, **characterized in that** a trench junction barrier Schottky diode (TJBS) in which the trench depth is 1-3 $\mu$m and the trench-to-trench distance is 0.5 - 1 $\mu$m is used as the Schottky diode.

**9.** Method according to any of the preceding claims, **characterized in that** diodes having a Schottky barrier of 0.65 eV to 0.75 eV are used as Schottky diodes.

**Revendications**

1. Procédé pour faire fonctionner un générateur comprenant un arrangement redresseur avec des diodes qui, comme élément semiconducteur, contiennent une diode Schottky, le générateur possédant un point chaud au niveau duquel une température de couche barrière des diodes est la plus élevée en fonction de la vitesse de rotation du générateur, la résistance thermique (Rth) entre la couche barrière du semiconducteur de l'élément semiconducteur et l'air ambiant lors du fonctionnement au point chaud du générateur ne dépassant pas une valeur prédéfinie, la température maximale admissible de la couche barrière des diodes étant conçue au moins pour le fonctionnement au point chaud, **caractérisé en ce que** le générateur, et ainsi les diodes Schottky (D1 à D6) fonctionnent dans une plage de travail dans laquelle les pertes des diodes augmentent à mesure que la température de la couche barrière augmente, et **en ce qu'**au point chaud, la température maximale admissible T de la couche barrière des diodes vérifie la relation suivante :

$$\frac{1}{2} \cdot UR \cdot Rth \cdot \frac{Ea}{T^2} \cdot IR(T) \leq 1$$

où Rth désigne la résistance thermique au point chaud, UR la tension de blocage, IR(T) le courant de blocage, T la température de la couche barrière et Ea l'énergie d'activation.

2. Procédé selon la revendication 1, **caractérisé en ce que** la résistance thermique entre la couche barrière du semiconducteur et l'air ambiant lors du fonctionnement au point chaud du générateur est inférieure à 7 K/W.

3. Procédé selon la revendication 1, **caractérisé en ce que** la résistance thermique entre la couche barrière du semiconducteur et l'air ambiant lors du fonctionnement au point chaud du générateur est inférieure à 5 K/W.

4. Procédé selon la revendication 1, **caractérisé en ce que** la résistance thermique entre la couche barrière du semiconducteur et l'air ambiant lors du fonctionnement au point chaud du générateur est inférieure à 3 K/W.

5. Procédé selon l'une des revendications précédentes, **caractérisé en ce que** la diode Schottky utilisée est une diode Schottky à barrière MOS à tranchée (TMBS).

6. Procédé selon la revendication 5, **caractérisé en ce que** la diode Schottky utilisée est une diode Schottky à barrière MOS à tranchée (TMBS) avec laquelle la profondeur de tranchée est de 1 à 3 $\mu$m et l'écart de tranchée à tranchée est de 0,5 à 1 $\mu$m.

7. Procédé selon l'une des revendications 1 à 4, **caractérisé en ce que** la diode Schottky utilisée est une diode Schottky à barrière de jonction à tranchée (TJBS).

8. Procédé selon l'une des revendications 1 à 4, **caractérisé en ce que** la diode Schottky utilisée est une diode Schottky à barrière de jonction à tranchée (TJBS) avec laquelle la profondeur de tranchée est de 1 à 3 $\mu$m et l'écart de tranchée à tranchée est de 0,5 à 1 $\mu$m.

9. Procédé selon l'une des revendications précédentes, **caractérisé en ce que** les diodes Schottky utilisées sont des diodes avec une barrière Schottky de 0,65 eV à 0,75 eV.

# Fig. 1

# Fig. 2

**Fig. 3**

## Fig. 4

## Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69428996 T2
- DE 102004053761 A1
- DE 102004056663